Europäisches Patentamt

European Patent Office

Office européen des brevets

(19)

(11)  **EP 1 238 458 B1**

(12)  **EUROPÄISCHE PATENTSCHRIFT**

(45) Veröffentlichungstag und Bekanntmachung des
Hinweises auf die Patenterteilung:
**21.05.2003   Patentblatt 2003/21**

(51) Int Cl.[7]:  **H03H 1/00**

(86) Internationale Anmeldenummer:
**PCT/DE00/04493**

(21) Anmeldenummer: **00990543.1**

(22) Anmeldetag: **13.12.2000**

(87) Internationale Veröffentlichungsnummer:
**WO 01/045253 (21.06.2001 Gazette 2001/25)**

(54) **SCHALTUNGSANORDNUNG UND VERFAHREN ZUR OFFSETKOMPENSATION EINES
SIGNALS**

CIRCUIT ARRANGEMENT AND A METHOD FOR THE OFFSET COMPENSATION OF A SIGNAL

CIRCUIT ET PROCEDE POUR LA COMPENSATION DE DECALAGE D'UN SIGNAL

(84) Benannte Vertragsstaaten:
**AT BE CH CY DE DK ES FI FR GB GR IE IT LI LU
MC NL PT SE TR**

(30) Priorität: **17.12.1999  DE 19961121**

(43) Veröffentlichungstag der Anmeldung:
**11.09.2002   Patentblatt 2002/37**

(73) Patentinhaber: **Infineon Technologies AG
81669 München (DE)**

(72) Erfinder: **NEUBAUER, André
47807 Krefeld (DE)**

(74) Vertreter: **Graf Lambsdorff, Matthias, Dr.
Patentanwälte
Lambsdorff & Lange
Dingolfinger Strasse 6
81673 München (DE)**

(56) Entgegenhaltungen:
**EP-A- 0 353 891          EP-A- 0 959 568
WO-A-97/27695**

**Beschreibung**

Die vorliegende Erfindung betrifft eine Schaltungsanordnung zur Offsetkompensation eines Signals, insbesondere eines frequenzmodulierten Empfangssignals in einem schnurlosen digitalen Kommunikationssystem, sowie ein Verfahren zur Offsetkompensation durch Anwendung einer derartigen Schaltungsanordnung, um in dem jeweiligen Signal enthaltene Niederfrequenz- oder Gleichstrom-Offsetanteile kompensieren zu können.

In vielen schnurlosen digitalen Kommunikationssystemen, wie z.B. Kommunikationssystemen gemäß dem DECT-, WDCT-, Bluetooth- oder SWAP-Mobilfunkstandard, werden zum Empfang von frequenzmodulierten Hochfrequenz-Signalen FM-Demodulatoren (Frequenzmodulation) verwendet. Als eine Art der digitalen Frequenzmodulation wird dabei häufig eine GFSK-Modulation (Gaussian Frequency Shift Keying) eingesetzt. Das Ausgangssignal derartiger FM-Demodulatoren wird in der Regel durch einen sich zeitlich langsam zeitabhängig verändernden Offset gestört, der durch Gerätetoleranzen, Frequenzoffsets oder Drift zwischen dem Sender und dem Empfänger verursacht wird. Dieser Offset ist a priori nicht bekannt.

Aus diesem Grund ist in den Empfängern der Einsatz von Schaltungsanordnungen zur Kompensation derartiger Offsets erforderlich, um nachfolgend die Symbole des offsetkompensierten Empfangssignals ungestört und korrekt entscheiden bzw. beurteilen zu können, wodurch die Leistungsfähigkeit des Empfängers optimiert und die Bitfehlerrate bei einem vorgegebenen Signal-Rausch-Abstand reduziert werden kann.

In herkömmlichen analogen Empfängern werden ausschließlich analoge Schaltungen verwendet, um einen Niederfrequenz- oder Gleichstrom-Offset zu kompensieren. Diese bekannten analogen Schaltungen bestehen aus einem analogen Tiefpaßfilter, um das Offsetsignal näherungsweise abzuschätzen und anschließend davon abhängig das tiefpaßgefilterte Signal von dem Eingangssignal zu subtrahieren, was insgesamt einer Hochpaßfilterung entspricht.

Dieses ausschließlich analoge Prinzip ist jedoch nicht geeignet, wenn relativ kurze Zeitabschnitte, wie beispielsweise die Präambel eines digitalen Bluetooth-Kommunikationssignals mit einer Dauer von lediglich 4µs, kompensiert bzw. gefiltert werden müssen.

In der Schrift WO 97/27695 A ist ein Empfänger mit einem rekursiven digitalen Filter beschrieben, wobei das Filter zur Eliminierung von Phasen- und Frequenz-Offsets aus einem empfangenen Signal dient. Zu diesem Zweck weist das Filter zeitlich veränderbare Filterkoeffizienten auf.

Der vorliegenden Erfindung liegt daher die Aufgabe zugrunde, eine Schaltungsanordnung und ein entsprechendes Verfahren zur Offsetkompensation eines Signals, insbesondere eines Kommunikationssignals, mit einer verbesserten Effektivität der Offsetkompensation bereitzustellen.

Diese Aufgabe wird erfindungsgemäß durch eine Schaltungsanordnung mit den Merkmalen des Anspruches 1 gelöst. Die Unteransprüche definieren vorteilhafte und bevorzugte Ausführungsformen der vorliegenden Erfindung.

Erfindungsgemäß wird davon ausgegangen, daß das zu kompensierende Signal in digitaler Form vorliegt. Zur Offsetkompensation wird kein analoges Filter, sondern ein rekursives digitales Filter verwendet, von dem ein oder mehrere Filterkoeffizienten zeitabhängig einstellbar sind

Auf diese Weise können unterschiedliche Kompensationsphasen realisiert werden. Insbesondere ist es somit möglich, die Präambel eines Zeitschlitzes oder Bursts eines digitalen Kommunikationssignals einer relativ schnellen Offsetkompensation und die eigentlichen Nutzinformationen desselben Zeitschlitzes oder Bursts einer eher langsamen Offsetkompensation zu unterziehen. Durch die der Erfindung zugrundeliegende zeitvariante Filterung bzw. durch das zuvor beschriebene Mehrphasenprinzip des rekursiven digitalen Filters wird die Kompensationseffektivität deutlich verbessert. Insbesondere können auch kurze zeitliche Abschnitte, wie beispielsweise die kurze Präambel eines Bluetooth-Kommunikationssignals, effektiv kompensiert werden.

Für das rekursive digitale Filter wird eine spezielle Ausgestaltung vorgeschlagen, die insbesondere ohne echte Multiplizierer auskommt und somit kosten- und aufwandsgünstig implementiert werden kann. Die Übertragungsfunktion H(z) des rekursiven digitalen Filters kann vorteilhafterweise dem Ausdruck $\frac{1}{1-\gamma} \cdot \frac{1-z^{-R}}{1-\gamma \cdot z^{-R}}$ entsprechen.

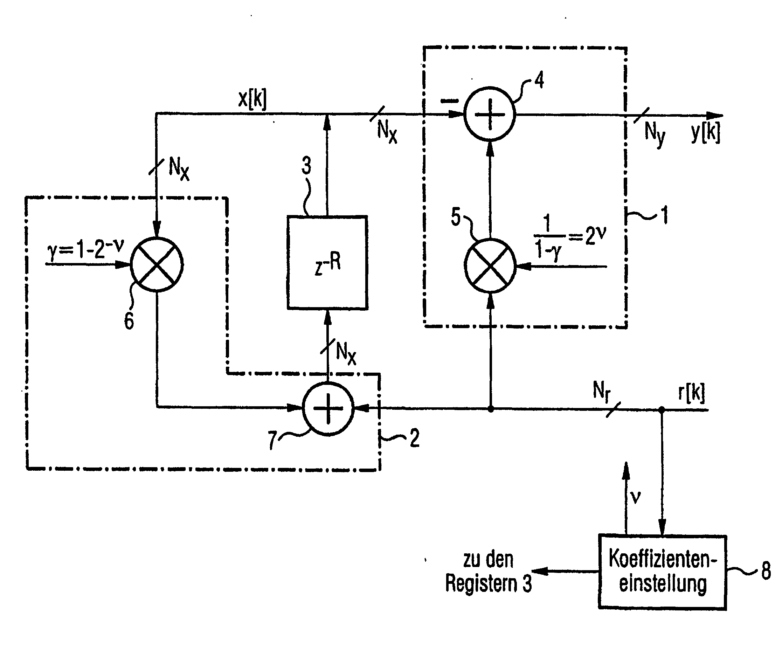

Die Erfindung wird nachfolgend näher unter Bezugnahme auf die beigefügte Zeichnung anhand eines bevorzugten Ausführungsbeispiels erläutert.

In der einzigen Figur ist ein rekursives digitales Filter (IIR-Filter, Infinite Impulse Resonse) mit zeitlich veränderbaren Filtereigenschaften dargestellt, welches zur Kompensation bzw. zur Beseitigung von Niederfrequenz-Offsetkomponenten eines dem rekursiven digitalen Filter zugeführten digitalen Eingangssignals $r[k]=r(k \cdot T_s)$ dient. Im vorliegenden Fall handelt es sich bei dem digitalen Eingangssignal um das analoge PAM-Ausgangssignal (Pulsamplitudenmodulation) eines in einem Empfänger eines entsprechenden digitalen Kommunikationssystems eingesetzten FM-Demodulators, welches digitalisiert, d.h. abgetastet und anschließend quantisiert, worden ist.

Das digitale Eingangssignal r[k] kann in überabgetasteter Form vorliegen, so daß gilt: $R = \frac{T_{bit}}{T_s}$

Dabei bezeichnet R den Überabtastfaktor, $T_s$ die Symboldauer des Eingangssignals r[k] und $T_{bit}$ die Dauer eines von dem Empfänger empfangenen Bits.

Durch die mit Hilfe des rekursiven digitalen Filters durchgeführte Offsetkompensation des digitalen Eingangssignals mit der Wortbreite $N_r$ wird ein hoch-

paßgefiltertes Ausgangssignal y[k] mit der Wortbreite $N_y$ erhalten.

Das rekursive digitale Filter umfaßt im wesentlichen einen Bitverschiebe- und Subtrahierabschnitt 1, einen Bitverschiebe- und Addierabschnitt 2 sowie eine Registereinheit 3.

Der Bitverschiebe- und Subtrahierabschnitt 1 umfaßt einen Multiplizierer 5 und einen Addierer 4, dem ein digitales Zwischensignal x[k] (Wortbreite $N_x$) mit negiertem Vorzeichen zugeführt wird. Der Multiplizierer 5 multipliziert die Symbole des digitalen Eingangssignals r[k] mit dem Faktor $2^\nu$, wobei der ganzzahlige Parameter $\nu$ von einer Steuerung 8 insbesondere zeitabhängig verändert und eingestellt wird. Mit Hilfe des Addierers 4 wird von dem Ausgangssignal des Multiplizierers 5 das Zwischensignal x[k] subtrahiert, um somit das digitale offsetkompensierte Ausgangssignal y[k] zu erhalten.

Der Bitverschiebe- und Addierabschnitt 2 umfaßt einen Multiplizierer 6 und einen Addierer 7. Der Multiplizierer 6 multipliziert die Symbole des digitalen Zwischensignals x[k] mit dem Faktor $1-2^{-\nu}$. Mit Hilfe des Addierers 7 wird das Ausgangssignal des Multiplizierers 6 mit dem Eingangssignal r[k] addiert und das Additionsergebnis der Registereinheit 3 zugeführt.

Die Registereinheit 3, welche R Register umfaßt, besitzt die Übertragungsfunktion $z^{-R}$ und gibt das Ausgangssignal des Addierers 7 zeitlich um R Symbole verzögert als das Zwischensignal x[k] aus. Die einzelnen Register der Registereinheit 3 können, wie nachfolgend noch näher erläutert wird, ebenfalls von der Steuerung 8 initialisiert werden.

Das dargestellte digitale IIR-Filter kann durch folgende Zustandsgleichungen beschrieben werden:

$$x[k+R]=\gamma \cdot x[k]+r[k]$$

$$y[k]=\frac{1}{1-\gamma} \cdot r[k]-x[k]$$

Die entsprechende Übertragungsfunktion H(z) des digitalen IIR-Filters lautet:

$$\frac{1}{1-\gamma} \cdot \frac{1-z^{-R}}{1-\gamma \cdot z^{-R}}$$

Der Filterkoeffizient ist wie in der Figur gezeigt durch $\gamma = 1-2^{-\nu}$ definiert.

Der Filterkoeffizient wurde wie zuvor beschrieben gewählt, um eine Realisierung des digitalen IIR-Filters ohne echte Multiplizierer zu ermöglichen. Da die von dem Filter verwendeten Filterkoeffizienten bzw. Multiplikationsfaktoren $2^\nu$ bzw. $1-2^{-\nu}$ jeweils durch Zweierpotenzen darstellbar sind, kann die Funktion der Multiplizierer 5, 6 durch einfache, dem Exponenten des jeweiligen Filterkoeffizienten entsprechende Bitverschiebeoperationen realisiert werden.

Nachfolgend soll der Betrieb des dargestellten digitalen Filters anhand eines in vordefinierte Zeitabschnitte, d.h. in Bursts oder Zeitschlitze, unterteilten empfangenen Kommunikationssignals r[k] erläutert werden, wobei die Offsetkompensation in mehreren aufeinanderfolgenden Phasen abläuft.

Zunächst wird zu Beginn eines empfangenen Bursts der Filterkoeffizienten-Parameter $\nu$ von der Steuerung 8 auf einen relativ kleinen Wert eingestellt und die interne $RxN_x$-Registereinheit 3 mit dem Wert Null initialisiert. Anschließend wird die Offsetkompensation des digitalen Empfangssignals r[k] auf Grundlage dieser Einstellungen durchgeführt. Aufgrund des relativ kleinen Werts für den Parameter $\nu$ erfolgt eine "schnelle" Kompensation, so daß sich diese Phase insbesondere zur Offsetkompensation der Präambel des Empfangssignals r[k], welche in der Regel Signalisierungs-, Synchronisier- und Zugriffsinformationen umfaßt, eignet.

Anschließend wird für die eigentlichen Nutzdaten des Bursts eine "langsame" Offsetkompensation durchgeführt. Zu diesem Zweck erfolgt eine neue Initialisierung des Parameters $\nu$ sowie der Registereinheit 3. Zur Initialisierung wird zunächst das digitale Empfangssignal r[k] über ein bestimmtes Zeitintervall akkumuliert, wobei die Länge dieses Zeitintervalls so gewählt wird, daß eine näherungsweise Schätzung des in dem Empfangssignal r[k] enthaltenen Offsets möglich ist. Das Zeitintervall entspricht der Länge $L \cdot T_{bit}$, d.h. $L \cdot R$ Abtastwerten oder Symbolen des Empfangssignals r[k]. Das Akkumulationsergebnis wird anschließend durch die Anzahl $L \cdot R$ der Symbole geteilt, um auf diese Weise einen arithmetischen Mittelwert $r_0$ zu ermitteln. Als Länge des Zeitintervalls kann beispielsweise $L \cdot R$=52 verwendet werden. In Abhängigkeit von dem somit berechneten Mittelwert $r_0$ werden die R Einzelregister mit der Wortlänge $N_x$ der Registereinheit 3 für die "langsame" Offsetkompensation mit dem Wert $2^\nu \cdot r_0$ initialisiert und der Parameter $\nu$ auf einen höheren Wert als zu Beginn des Bursts eingestellt. Anschließend erfolgt bis zum Ende des entsprechenden Bursts die "langsame" Offsetkompensation oder Filterung des digitalen Empfangssignals r[k] auf Grundlage dieser neuen Einstellungen.

Während eines Bursts werden somit zwei unterschiedliche Initialisierungsphasen durchgeführt. Für die erste Initialisierung des rekursiven digitalen Filters wird keine a-priori-Information verwendet, während für die zweite Initialisierung am Ende des Präambelbereichs empfangene Signalmuster ausgenutzt werden. Dabei kann es sich beispielsweise um am Ende eines Synchronisationsworts übertragene Signalmuster etc. handeln. Auf Grundlage dieser unterschiedlichen Initialisierungen werden zwei unterschiedliche Filter- oder Offsetkompensationsphasen durchgeführt: die "schnelle" erste Filterung deckt dabei insbesondere die in der Präambel übertragenen Zugriffsinformationen ab, während die "langsame" zweite Filterung für die eigentlichen Nutzinformationen des jeweiligen Bursts durchgeführt wird.

**Patentansprüche**

1. Schaltungsanordnung zur Offsetkompensation eines Signals, wobei die Schaltungsanordnung in Form eines rekursiven digitalen Filters ausgestaltet ist, dem ein zu kompensierendes digitales Eingangssignal (r) zugeführt wird, und wobei mindestens ein Filterkoeffizienz ($\gamma$, $\nu$) des rekursiven digitalen Filters zeitlich veränderbar ist,
   **dadurch gekennzeichnet,**
   **daß** das rekursive digitale Filter eine erste Multipliziereinrichtung (5) und eine Subtrahiereinrichtung (4) umfaßt, wobei die erste Multipliziereinrichtung (5) die Symbole des zu kompensierenden digitalen Eingangssignals (r) mit einem ersten zeitlich veränderbaren Filterkoeffizienten multipliziert und wobei die Subtrahiereinrichtung (4) die Symbole eines digitalen Zwischensignals (x) von den Symbolen des digitalen Ausgangssignals der ersten Multipliziereinrichtung (5) subtrahiert, um somit die Symbole eines offsetkompensierten digitalen Ausgangssignals (y) zu erhalten,
   **daß** das rekursive digitale Filter eine zweite Multipliziereinrichtung (6) und eine Addiereinrichtung (7) umfaßt, wobei die zweite Multipliziereinrichtung (6) die Symbole des digitalen Zwischensignals (x) mit einem zweiten zeitlich veränderbaren Filterkoeffizienten multipliziert und wobei die Addiereinrichtung (7) die Symbole des digitalen Ausgangssignals der zweiten Multipliziereinrichtung (6) mit den Symbolen des digitalen Eingangssignals (r) addiert, und daß das rekursive digitale Filter eine Registereinrichtung (3) umfaßt, welches die Symbole des digitalen Ausgangssignals der Addiereinrichtung (7) empfängt und die Symbole des digitalen Zwischensignals (x) ausgibt.

2. Schaltungsanordnung nach Anspruch 1,
   **dadurch gekennzeichnet,**
   **daß** der erste und zweite Filterkoeffizient derart gewählt sind, daß sie sich durch Zweierpotenzen darstellen lassen, und
   **daß** die erste und zweite Multipliziereinrichtung (5, 6) in Form von Bitverschiebeeinrichtungen realisiert sind, welche den jeweiligen Eingangssymbolwert um eine dem Exponenten der den ersten bzw. zweiten Filterkoeffizienten darstellenden Zweierpotenz entsprechende Anzahl von Bitpositionen verschieben.

3. Schaltungsanordnung nach Anspruch 1 oder 2,
   **dadurch gekennzeichnet**,
   daß die Registereinrichtung (3) entsprechend der Übertragungsfunktion $z^{-R}$ ausgestaltet ist, wobei R ein Überabtastungsverhältnis, mit dem die Symbole des zu kompensierenden digitalen Eingangssignals (r) vorliegen, bezeichnet.

4. Schaltungsanordnung nach einem der vorhergehenden Ansprüche,
   **dadurch gekennzeichnet,**
   **daß** der erste Filterkoeffizient der ersten Multipliziereinrichtung (5) dem Wert $2^\nu$ und der zweite Filterkoeffizient der zweiten Multipliziereinrichtung (6) dem Wert $1-2^{-\nu}$ entspricht, wobei $\nu$ einen zeitlich veränderbaren ganzzahligen Parameter bezeichnet.

5. Schaltungsanordnung nach einem der vorhergehenden Ansprüche,
   **dadurch gekennzeichnet,**
   **daß** das rekursive digitale Filter entsprechend der Übertragungsfunktion $\frac{1}{1-\gamma} \cdot \frac{1-z^{-R}}{z^{-R}}$ ausgestaltet ist, wobei R ein Überabtastungsverhältnis, mit dem die Symbole des zu kompensierenden digitalen Eingangssignals (r) vorliegen, und $\gamma$ dem zeitlich veränderbaren Filterkoeffizienten entspricht.

6. Schaltungsanordnung nach Anspruch 4 und 5,
   **dadurch gekennzeichnet,**
   **daß** die Beziehung: $\gamma = 1-2^{-\nu}$ gilt.

7. Schaltungsanordnung nach einem der vorhergehenden Ansprüche,
   **dadurch gekennzeichnet,**
   **daß** Steuermittel (8) vorhanden sind, um den mindestens einen variablen Filterkoeffizienten ($\gamma$, $\nu$) des rekursiven digitalen Filters zeitlich abhängig von dem Eingangssignal (r) einzustellen.

8. Schaltungsanordnung nach Anspruch 7 und Anspruch 4 oder 6,
   **dadurch gekennzeichnet,**
   **daß** das digitale Eingangssignal (r) in vordefinierte Zeitabschnitte unterteilt ist, und
   **daß** die Steuermittel (8) derart ausgestaltet sind, daß sie zu Beginn jedes Zeitabschnitts den Parameter $\nu$ auf einen ersten Wert einstellen und die Register der Registereinrichtung (3) mit Null initialisieren, um anschließend während einer ersten Phase des entsprechenden Zeitabschitts die Offsetkompensation auf Grundlage dieser Einstellungen durchzuführen, und
   **daß** die Steuermittel (8) derart ausgestaltet sind, daß sie den Parameter $\nu$ nach Ablauf der ersten Phase auf einen zweiten Wert einstellen, welcher höher als der erste Wert dieses Parameters $\nu$ ist, und den Mittelwert $r_0$ über eine bestimmte Anzahl an Symbolen des Eingangssignals (r) bilden und die Register der Registereinrichtung (3) mit dem Wert $2^\nu$-$r_0$ initialisieren, um anschließend während einer zweiten Phase des entsprechenden Zeitabschitts die Offsetkompensation auf Grundlage dieser Binstellungen durchzuführen.

9. Schaltungsanordnung nach Anspruch 8,
   **dadurch gekennzeichnet,**
   **daß** das digitale Eingangssignal (r) ein Kommunikationssignal ist, und
   **daß** die zeitliche Länge der ersten und zweiten Phase jedes Zeitabschnitts derart gewählt ist, daß durch die erste Phase in dem jeweiligen Zeitabschnitt enthaltene Präambelinformationen und durch die zweite Phase in dem jeweiligen Zeitabschnitt enthaltene Nutzinformationen des Kommunikationssignals offsetkompensiert werden.

10. Verwendung der Schaltungsanordnung nach einem der vorhergehenden Ansprüche in einem digitalen Empfänger eines Bluetooth-Kommunikationssystems.

**Claims**

1. Circuit arrangement for the offset compensation of a signal, wherein the circuit arrangement is constructed in the form of a recursive digital filter which is supplied with a digital input signal (r) to be compensated, at least one filter coefficient ($\gamma$, $\nu$) of the recursive digital filter being time-variable,
   **characterized in that** the recursive digital filter comprises a first multiplying device (5) and a subtracting device (4), the first multiplying device (5) multiplying the symbols of the digital input signal (r) to be compensated for by a first time-variable filter coefficient and the subtracting device (4) subtracting the symbols of a digital intermediate signal (x) from the symbols of the digital output signal of the first multiplying device (5) in order to thus obtain the symbols of an offset-compensated digital output signal (y),
   **in that** the recursive digital filter comprises a second multiplying device (6) and an adding device (7), the second multiplying device (6) multiplying the symbols of the digital intermediate signal (x) by a second time-variable filter coefficient and the adding device (7) adding the symbols of the digital output signal of the second multiplying device (6) by the symbols of the digital input signal (r), and **in that** the recursive digital filter comprises a register device (3) which receives the symbols of the digital output signal of the adding device (7) and outputs the symbols of the digital intermediate signal (x).

2. Circuit arrangement according to Claim 1, **characterized in that** the first and second filter coefficient are selected in such a manner that they can be represented by powers of two and
   **in that** the first and second multiplying device (5, 6) are implemented in the form of bit-shifting devices which shift the respective input symbol value by a number of bit positions corresponding to a power of two representing the exponent of the first and second filter coefficient, respectively.

3. Circuit arrangement according to Claim 1 or 2, **characterized in that** the register device (3) is constructed in accordance with the transfer function $z^{-R}$, R designating an oversampling ratio with which the symbols of the digital input signal (r) to be compensated for are present.

4. Circuit arrangement according to one of the preceding claims, **characterized in that** the first filter coefficient of the first multiplying device (5) corresponds to the value $2^{\nu}$ and the second filter coefficient of the second multiplying device (6) corresponds to the value $1-2^{-\nu}$, $\nu$ designating a time-variable integral parameter.

5. Circuit arrangement according to one of the preceding claims, **characterized in that** the recursive digital filter is constructed in accordance with the transfer function $\frac{1}{1-\gamma} \cdot \frac{1-z^{-R}}{1-\gamma \cdot z^{-R}}$, R corresponding to an oversampling ratio with which the symbols of the digital input signal (r) to be compensated for are present, and $\gamma$ corresponding to the time-variable filter coefficient.

6. Circuit arrangement according to claim 4 and 5, **characterized in that** the relation $\gamma = 1-2^{-\nu}$ holds true.

7. Circuit arrangement according to one of the preceding claims, **characterized in that** control means (8) are provided in order to set the at least one variable filter coefficient ($\gamma$, $\nu$) of the recursive digital filter in time-dependence on the input signal (r).

8. Circuit arrangement according to Claim 7 and Claim 4 or 6, **characterized in that** the digital input signal (r) is subdivided into predefined time intervals and **in that** the control means (8) are constructed in such a manner that they set the parameter $\nu$ to a first value at the beginning of each time interval and initialize the registers of the register device (3) with zero in order to then carry out the offset compensation on the basis of these settings during a first phase of the corresponding time interval, and **in that** the control means (8) are constructed in such a manner that, after the first phase has been completed, they set the parameter $\nu$ to a second value which is higher than the first value of this parameter $\nu$ and form the mean $r_0$ over a particular number of symbols of the input signal (r) and initialize the registers of the register device (3) with the value $2^{\nu} \cdot r_0$ in order to then carry out the offset compensation on the basis of these settings during a second phase of the corresponding time interval.

9. Circuit arrangement according to Claim 8, **characterized in that** the digital input signal (r) is a communication signal, and
**in that** the length in time of the first and second phase of each time interval is selected in such a manner that preamble information contained in the respective time interval is offset-compensated by the first phase and user information of the communication signal contained in the respective time interval is offset-compensated by the second phase.

10. Use of the circuit arrangement according to one of the preceding claims in a digital receiver of a bluetooth communication system.


**Revendications**

1. Montage de compensation du décalage d'un signal, le montage ayant la forme d'un filtre récursif numérique auquel est envoyé un signal (r) numérique d'entrée à compenser et dans lequel au moins un coefficient ($\gamma$, $\nu$) de filtrage du filtre récursif numérique peut être modifié dans le temps,
**caractérisé,**
**en ce que** le filtre récursif numérique comprend un premier dispositif (5) de multiplication et un dispositif (4) de soustraction, le premier dispositif (5) de multiplication multipliant les symboles du signal (r) numérique d'entrée à compenser par un premier coefficient de filtrage qui peut être modifié dans le temps et le dispositif (4) de soustraction soustrayant les symboles d'un signal (x) intermédiaire numérique des symboles de signal numérique de sortie du premier dispositif (5) de multiplication pour obtenir ainsi les symboles d'un signal (y) numérique de sortie dont le décalage est compensé,
**en ce que** le filtre récursif numérique comprend un deuxième dispositif (6) de multiplication et un dispositif (7) d'addition, le deuxième dispositif (6) de multiplication multipliant les symboles du signal (x) intermédiaire numérique par un deuxième coefficient de filtrage qui peut être modifié dans le temps et le dispositif (7) d'addition additionnant les symboles du signal numérique de sortie du deuxième dispositif (6) de multiplication aux symboles du signal (r) numérique de sortie, et
**en ce que** le filtre récursif numérique comprend un dispositif (3) à registre qui reçoit les symboles du signal numérique de sortie du dispositif (7) d'addition et qui émet les symboles du signal (x) intermédiaire numérique.

2. Montage suivant la revendication 1, **caractérisé en ce que** le premier et le deuxième coefficients de filtrage sont choisis de manière à pouvoir être représentés par des puissances de deux, et
**en ce que** le premier et le deuxième dispositifs (5, 6) de multiplication sont réalisés sous la forme de dispositifs à décalage de bit qui décalent la valeur de symbole d'entrée respective d'un nombre de positions correspondant à l'exposant de la puissance de deux représentant le premier ou le deuxième coefficient de filtrage.

3. Montage suivant la revendication 1 ou 2, **caractérisé en ce que** le dispositif (3) à registre est conformé conformément à la fonction de transfert $z^{-R}$, R étant un rapport de suréchantillonnage avec lequel se présentent les symboles du signal (r) numérique d'entrée à compenser.

4. Montage suivant l'une des revendications précédentes, **caractérisé en ce que** le premier coefficient de filtrage du premier dispositif (5) de multiplication correspond à la valeur $2^\nu$ et le deuxième coefficient de filtrage du deuxième dispositif (6) de multiplication a la valeur $1-2^{-\nu}$ désignant un paramètre en nombre entier qui peut être modifié dans le temps.

5. Montage suivant l'une des revendications précédentes, **caractérisé en ce que** le filtre récursif numérique est conformé conformément à la fonction de transfert $\frac{1}{1-\gamma} \cdot \frac{1-z^{-R}}{1-z^{-R}}$ dans laquelle R est un rapport de suréchantillonnage avec lequel les symboles du signal (r) numérique d'entrée à compenser se présentent et $\gamma$ correspond au coefficient de filtrage qui peut être modifié dans le temps.

6. Montage suivant les revendications 4 et 5, **caractérisé en ce que** l'on a la relation $\gamma = 1-2^{-\nu}$.

7. Montage suivant l'une des revendications précédentes, **caractérisé en ce qu'**il est prévu des moyens (8) de commande pour régler le au moins un coefficient ($\gamma$, $\nu$) de filtrage variable du filtre récursif numérique dans le temps en fonction du signal (r) d'entrée.

8. Montage suivant la revendication 7 et la revendication 4 ou 6,
**caractérisé**
**en ce que** le signal (r) numérique d'entrée est subdivisé en des laps de temps définis à l'avance, et
**en ce que** les moyens (8) de commande sont réalisés de façon à ce qu'il mette au début de chaque laps de temps le paramètre $\nu$ à une première valeur et initialise les registres du dispositif (3) à registre à zéro et ensuite pendant une première phase du laps de temps correspondant, effectue la compensation de décalage sur la base de ces réglages, et

**en ce que** les moyens (8) de commande sont réalisés de façon à ce qu'ils mettent le paramètre $\nu$, après déroulement de la première phase, à une deuxième valeur qui est plus grande que la première valeur de ce paramètre $\nu$ et forment la valeur $T_0$ moyenne sur un nombre déterminé de symboles du signal (r) d'entrée et initialisent les registres du dispositif (3) à registre à la valeur $2^{\nu}-r_0$ et ensuite pendant une deuxième phase du laps de temps correspondant effectuent la compensation du décalage sur la base de ces réglages.

9. Montage suivant la revendication 8, **caractérisé en ce que** le signal (r) numérique d'entrée est un signal de télécommunication et **en ce que** la longueur dans le temps de la première et de la deuxième phases de chaque laps de temps est choisie de façon à ce que soient compensées en décalage, par la première phase, des informations de préambule contenues dans le laps de temps et, par la deuxième phase, des informations utiles du signal de télécommunication contenues dans le laps de temps.

10. Utilisation du montage suivant l'une des revendications précédentes dans un récepteur numérique d'un système de télécommunications Bluetooth.

EP 1 238 458 B1